Europäisches Patentamt

European Patent Office

Office européen des brevets

(19)

(11)     **EP 1 125 009 B1**

(12)     **EUROPEAN PATENT SPECIFICATION**

(45) Date of publication and mention
of the grant of the patent:
**18.12.2002   Bulletin 2002/51**

(51) Int Cl.[7]: **C30B 15/30**, C30B 15/20,
C30B 29/06

(21) Application number: **99951943.2**

(22) Date of filing: **12.10.1999**

(86) International application number:
**PCT/US99/23735**

(87) International publication number:
**WO 00/022201 (20.04.2000 Gazette 2000/16)**

(54) **METHOD FOR ACCURATELY PULLING A CRYSTAL**

VERFAHREN ZUR GENAUEN ZIEHUNG EINES KRISTALLES

PROCEDE PERMETTANT DE TIRER UN CRISTAL AVEC PRECISION

(84) Designated Contracting States:
**DE FR GB IT**

(30) Priority: **14.10.1998   US 104289 P**
**12.08.1999   US 372897**

(43) Date of publication of application:
**22.08.2001   Bulletin 2001/34**

(73) Proprietor: **MEMC Electronic Materials, Inc.**
**St. Peters, Missouri 63376 (US)**

(72) Inventors:
• **WYAND, Robert, R., III MEMC Elec. Materials, Inc.**
**St. Peters, MO 63376 (US)**
• **FUERHOFF, Robert, H.**
**MEMC Elec. Materials, Inc.**
**St. Louis, MO 63376 (US)**
• **JOHNSON, Bayard, K.**
**Pennsylvania 15025-3701 (US)**

(74) Representative: **Smaggasgale, Gillian Helen et al**
**W.P. Thompson & Co,**
**Celcon House,**
**289-293 High Holborn**
**London WC1V 7HU (GB)**

(56) References cited:
**EP-A- 0 437 775           EP-A- 0 444 628**
**FR-A- 2 071 788           US-A- 3 761 692**
**US-A- 4 663 128**

• **PATENT ABSTRACTS OF JAPAN vol. 1997, no. 07, 31 July 1997 (1997-07-31) & JP 09 087083 A (SUMITOMO METAL IND LTD;SUMITOMO SITIX CORP), 31 March 1997 (1997-03-31)**
• **AMMON VON W ET AL: "THE DEPENDENCE OF BULK DEFECTS ON THE AXIAL TEMPERATURE GRADIENT OFSILICON CRYSTALS DURING CZOCHRALSKI GROWTH" JOURNAL OF CRYSTAL GROWTH,NL,NORTH-HOLLAND PUBLISHING CO. AMSTERDAM, vol. 151, no. 3/04, page 273-277 XP000514096 ISSN: 0022-0248**

**Description**

BACKGROUND OF THE INVENTION

This invention relates generally to improvements in controlling growth processes of single crystal semiconductors for use in the manufacture of electronic components and, particularly, to a method and apparatus for accurately controlling pull rate in a Czochralski crystal growth process according to a predetermined velocity profile.

Monocrystalline, or single crystal, silicon is the starting material in most processes for fabricating semiconductor electronic components. Crystal pulling machines employing the Czochralski process produce the majority of single crystal silicon. Briefly described, the Czochralski process involves melting a charge of high-purity polycrystalline silicon in a quartz crucible located in a specifically designed furnace. After the heated crucible melts the silicon charge, a crystal lifting mechanism lowers a seed crystal into contact with the molten silicon. The mechanism then withdraws the seed to pull a growing crystal from the silicon melt. A typical crystal lifting mechanism suspends the seed crystal from one end of a cable, the other end of which is wrapped around a drum. As the drum rotates, the seed crystal moves up or down depending on the direction that the drum is rotating. A Czochralski crystal puller of the type wherein a cable used to suspend the crystal is wound and unwound by means of a rotatable drum is disclosed in European Patent Publication No. 0437775.

After formation of a crystal neck, the growth process enlarges the diameter of the growing crystal by decreasing the pulling rate and/or the melt temperature until a desired diameter is reached. By controlling the pull rate and the melt temperature while compensating for the decreasing melt level, the main body of the crystal is grown so that it has an approximately constant diameter (*i.e.*, it is generally cylindrical). Near the end of the growth process but before the crucible is emptied of molten silicon, the process gradually reduces the crystal diameter to form an end cone. Typically, the end cone is formed by increasing the crystal pull rate and heat supplied to the crucible. When the diameter becomes small enough, the crystal is then separated from the melt. During the growth process, the crucible rotates the melt in one direction and the crystal lifting mechanism rotates its pulling cable, or shaft, along with the seed and the crystal, in an opposite direction.

Although presently available Czochralski growth processes have been satisfactory for growing single crystal silicon useful in a wide variety of applications, further improvements are still desired. For example, a number of defects in single crystal silicon form in the crystal growth chamber as the crystal ingot cools after solidification. Such defects arise, in part, due to the presence of an excess (*i.e.*, a concentration above the solubility limit) of intrinsic point defects known as vacancies and self-interstitials. It has been suggested that the type and initial concentration of these point defects in the silicon can influence the type and presence of agglomerated defects in the final product. If these concentrations reach a level of critical supersaturation in the system and the mobility of the point defects is sufficiently high, a reaction, or an agglomeration event, will likely occur. Agglomerated intrinsic point defects in silicon can severely impact the yield potential of the material in the production of complex integrated circuits.

For these reasons, an accurate and reliable apparatus and method for pulling a single crystal silicon ingot from a melt is desired for reducing the number and concentration of intrinsic point defects in the ingot.

**SUMMARY OF THE INVENTION**

The invention meets the above needs and overcomes the deficiencies of the prior art by providing a method and apparatus for accurately pulling a crystal ingot from a melt according to a predetermined velocity profile. Among the several objects of the invention may be noted the provision of such method and apparatus that reduce the number and concentration of intrinsic point defects in a single crystal silicon ingot; the provision of such method and apparatus that control the concentration of vacancies and self-interstitials in a single crystal silicon ingot to prevent an agglomeration of intrinsic point defects in the ingot as the ingot cools from the solidification temperature; the provision of such method and apparatus that may be incorporated into existing crystal pulling devices; and the provision of such method that can be carried out efficiently and economically and such apparatus that is economically feasible and commercially practical.

Briefly described, a method embodying aspects of the invention is for use with a crystal growing apparatus for growing a monocrystalline ingot according to the Czochralski process. The apparatus has a heated crucible containing a semiconductor melt from which the ingot is grown on a seed crystal that is pulled from the melt. The apparatus also has a cable from which the seed crystal is suspended and a drum on which a portion of the cable is wound. Rotating the drum in one direction winds the cable to pull the ingot from the melt and rotating the drum in an opposite direction unwinds the cable to lower the ingot toward the melt. The method includes the step of defining a predetermined velocity profile. The velocity profile defines a target rate for pulling the ingot from the melt as a function of the length of the ingot. According to the method, rotating the drum at a varying speed with a motor pulls the ingot from the melt at a varying rate. The steps of detecting rotational movement of the drum and generating a position signal representative of the detected rotational movement follow. The method also includes determining an actual pull rate of the ingot based on the position signal and comparing the actual pull rate of the ingot to the target pull rate defined by the velocity profile. The method further includes the step of controlling the speed of the motor to maintain the actual pull rate of the ingot approximately equal to the target pull rate during the pulling of at least about 50% of the length of the ingot.

Also described is an apparatus for use with a crystal growing apparatus for growing a monocrystalline ingot according to the Czochralski process. The apparatus has a heated crucible containing a semiconductor melt from which the ingot is grown on a seed crystal pulled from the melt. The apparatus also has a cable from which the seed crystal is suspended and a drum on which a portion of the cable is wound. Rotating the drum in one direction winds the cable to pull the ingot from the melt and rotating the drum in an opposite direction unwinds the cable to lower the ingot toward the melt. The apparatus includes a motor having a shaft coupled to the drum for rotating the drum. By rotating the drum at a varying speed, the motor pulls the ingot from the melt at a varying rate. The apparatus also includes a detector for detecting rotational movement of the drum and generating a position signal representative of the detected rotational movement. A memory stores a predetermined velocity profile that defines a target rate for pulling the ingot from the melt as a function of the length of the ingot. The apparatus further includes a controller responsive to the position signal and the velocity profile for controlling the speed of the motor to pull the ingot from the melt. The controller determines an actual pull rate of the ingot based on the position signal and compares the actual pull rate of the ingot to the target pull rate defined by the velocity profile. The controller then controls the speed of the motor to maintain the actual pull rate of the ingot approximately equal to the target pull rate during the pulling of at least about 50% of the length of the ingot.

Yet another embodiment is directed to a method for use with a crystal growing apparatus for growing a monocrystalline ingot according to the Czochralski process. The apparatus has a heated crucible containing a semiconductor melt from which the ingot is grown on a seed crystal that is pulled from the melt. The apparatus also has a cable from which the seed crystal is suspended and a drum on which a portion of the cable is wound. Rotating the drum in one direction winds the cable to pull the ingot from the melt and rotating the drum in an opposite direction unwinds the cable to lower the ingot toward the melt. The method includes the steps of pulling the ingot from the melt by rotating the drum with a motor, setting a first nominal pull rate and defining a set point corresponding to the first nominal pull rate. According to the method, energizing the motor as a function of the set point pulls the ingot from the melt at the first nominal rate. The method also includes detecting rotational movement of the drum, and generating a position signal representative of the detected rotational movement and then determining an actual pull rate of the ingot based on the position signal. The method further includes the steps of comparing the actual pull rate of the ingot to the first nominal pull rate and adjusting the set point until the difference between the actual pull rate of the ingot and the first nominal pull rate is less than or equal to a threshold level.

Other objects and features will be in part apparent and in part pointed out hereinafter.

## BRIEF DESCRIPTION OF THE DRAWINGS

FIG. 1 is an illustration of a crystal growing apparatus and an apparatus according to the present invention for controlling the crystal growing apparatus.

FIG. 2 is a block diagram of the apparatus of FIG. 1 including a control unit having a programmable logic controller (PLC).

FIG. 3 is a flow diagram illustrating the operation of the control unit for calibrating the apparatus of FIG. 1.

FIG. 4 is a velocity profile for pulling a crystal ingot having a reduced number and concentration of intrinsic point defects with the apparatus of FIG. 1.

FIG. 5 is a block diagram of the apparatus of FIG. 1 operating to calculate a modified set point.

FIGS. 6A and 6B are a flow diagram illustrating the operation of the PLC of FIG. 2 for calculating a correction factor.

Corresponding reference characters indicate corresponding parts throughout the drawings.

## DETAILED DESCRIPTION OF PREFERRED EMBODIMENTS

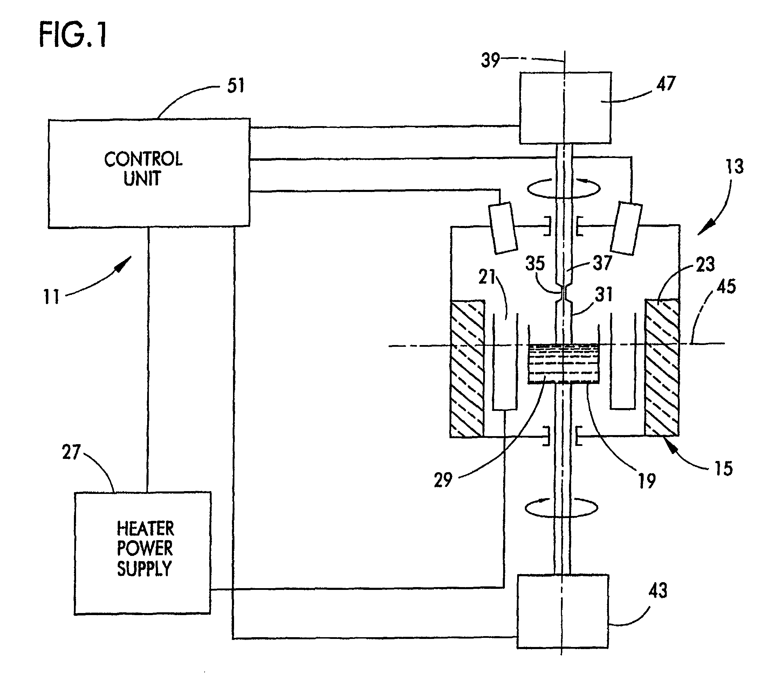

Referring now to FIG. 1, an apparatus, indicated generally at 11, is shown for use with a Czochralski crystal growing apparatus, indicated generally at 13. The details of construction of the crystal growing apparatus 13 are well known to those of ordinary skill in the art. In general, crystal growing apparatus 13 includes a vacuum chamber 15 enclosing a crucible 19. Heating means such as a resistance heater 21 surrounds the crucible 19. In one embodiment, insulation 23 lines the inner wall of vacuum chamber 15 and a chamber cooling jacket (not shown) fed with water surrounds it. A vacuum pump (not shown) typically removes gas from within the vacuum chamber 15 as an inert atmosphere of argon gas is fed into it.

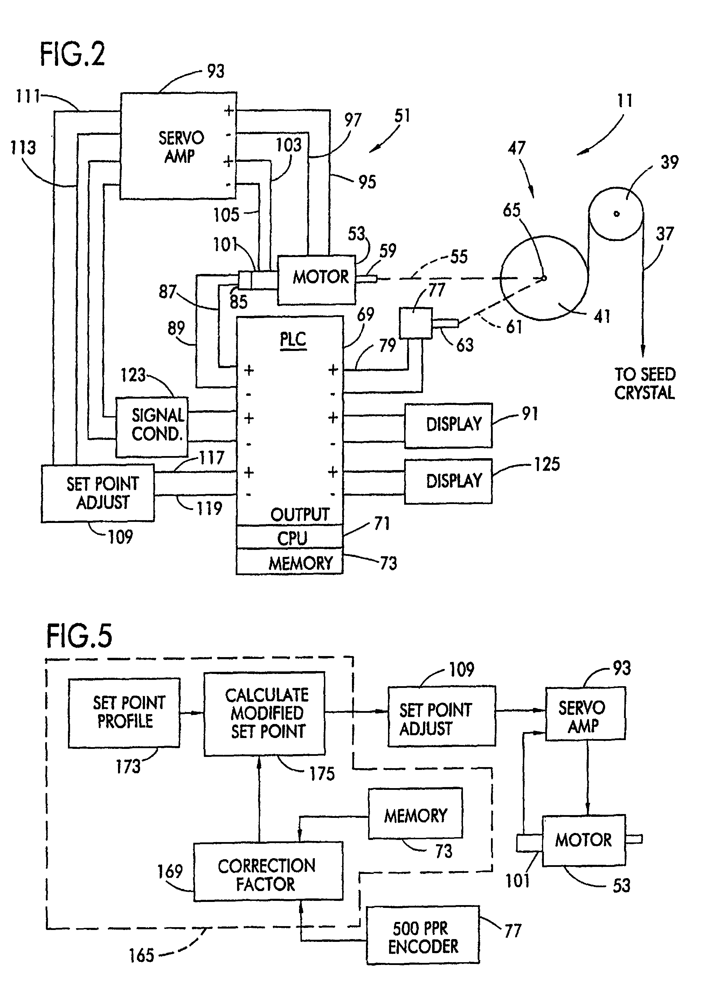

According to the Czochralski single crystal growth process, a quantity of polycrystalline silicon, or polysilicon, is charged to crucible 19. A heater power supply 27 provides electric current through the resistance heater 21 to melt the charge and, thus, form a silicon melt 29 from which a single crystal 31 is pulled. As is known in the art, the single crystal 31 starts with a seed crystal 35 attached to a pull shaft, or cable, 37. As shown in FIG. 1, single crystal 31 and crucible 19 generally have a common axis of symmetry 39. One end of cable 37 is connected to by way of a pulley 39 (see FIG. 2) to a drum 41 (see FIG. 2) and the other end is connected to a chuck (not shown) that holds the seed crystal 35 and the crystal 31 grown from the seed crystal.

During both heating and crystal pulling, a crucible drive unit 43 rotates crucible 19 (*e.g.*, in the clockwise direction). The crucible drive unit 43 also raises and lowers crucible 19 as desired during the growth process. For example, crucible drive unit 43 raises crucible 19 as the melt 29 is depleted to maintain its level, indicated by reference character 45, at a desired height. A crystal drive unit 47 similarly rotates the cable 37 in a direction opposite the direction in which crucible drive unit 43 rotates crucible 19. In addition, the crystal drive unit 47 raises and lowers crystal 31 relative to the melt level 45 as desired during the growth process.

In one embodiment, crystal growth apparatus 13 preheats the seed crystal 35 by lowering it nearly into contact with the molten silicon of melt 29 contained by crucible 19. After preheating, crystal drive unit 47 continues to lower seed crystal 35 via cable 37 into contact with melt 29 at its melt level 45. As seed crystal 35 melts, crystal drive unit 47 slowly withdraws, or pulls, it from the melt 29. Seed crystal 35 draws silicon from melt 29 to produce a growth of silicon single crystal 31 as it is withdrawn. Crystal drive unit 47 rotates crystal 31 at a reference rate as it pulls crystal 31 from melt 29. Crucible drive unit 43 similarly rotates crucible 19 at another reference rate, but usually in the opposite direction relative to crystal 31.

A control unit 51 initially controls the withdrawal, or pull, rate and the power that power supply 27 provides to heater 21 to cause a neck down of crystal 31. Preferably, crystal growth apparatus 13 grows the crystal neck at a substantially constant diameter as seed crystal 35 is drawn from melt 29. For example, the control unit 51 maintains a substantially constant neck diameter of about five percent of the desired body diameter. Under a conventional control scheme, control unit 51 adjusts the rotation, pull and/or heating parameters after the neck reaches a desired length to cause the diameter of crystal 31 to increase in a cone-shaped manner until a desired crystal body diameter is reached. For example, the control unit 51 decreases the pull rate to create an outwardly flaring region typically referred to as the taper of the crystal.

Once the desired crystal diameter is reached, control unit 51 controls the growth parameters to maintain a relatively constant diameter as measured by system 11 until the process approaches its end. At that point, the pull rate and heating are usually increased for decreasing the diameter to form a tapered portion at the end of single crystal 31. U.S. Patent No. 5,178,720 discloses one preferred method for controlling crystal and crucible rotation rates as a function of the crystal diameter. U.S. Patent No. 5,882,402, U.S. Patent No. 5,846,318, U.S. Patent No. 5,665,159 and U.S. Patent No. 5,653,799 provide accurate and reliable measurements of a number of crystal growth parameters, including crystal diameter. In these patents, an image processor processes images of the crystal-melt interface to determine the diameter.

FIG. 2 illustrates electrical circuitry embodying control unit 51 for controlling, among other things, crystal drive unit 47. The details of construction of crystal drive unit 47 are well known to those of ordinary skill in the art. Generally, drive unit 47 includes a motor 53 coupled to the drum 41. A dashed line 55 indicates the mechanical coupling between a shaft 59 of the motor 53 and drum 41. Although this mechanical coupling may comprise a direct connection between shaft 59 and drum 41, a preferred arrangement positions a set of reduction gears (not shown) between shaft 59 and drum 41 for better control and smoother operation. Motor 53 is thus operable to let out and reel in cable 37 via drum 41 for lowering seed crystal 35 into melt 29 and for pulling the ingot 31 from melt 29.

A dashed line 61 in FIG. 2 indicates the mounting of drum 41 on a shaft 63 through an opening 65 in drum 41. International Patent Application No. PCT/US98/23805 (European Patent Application No. 98956673.2) filed 10 November 1998, now published as International Patent Publication No. WO 99/2165 (European Patent Publication No. 1034323) shows a drum and cable arrangement suitable for use with the present invention.

Referring further to FIG. 2, control circuit 51 includes a programmable logic controller (PLC) 69 having a central processing unit (CPU) 71 and a memory 73. The PLC 69 receives an input signal from a 500 pulse per revolution (ppr) encoder 77 via lines 79 and 81. The encoder 77 is coupled to the shaft 63 for producing a position signal, In this instance, the position signal is made up of pulses on lines 79 and 81 that vary as a function of the rotational movement of drum 41. PLC 69 thus counts the pulses on lines 79 and 81 to determine exactly how much drum 41 has rotated during any given period of interest. Encoder 77 is preferably operated in a 2X mode wherein the encoder emits 1000 discrete pulses for each 360 degree rotation of drum 41. Accordingly, if PLC 69 counts 5,500 pulses on lines 79 and 81, then it is known that drum 41 rotated exactly five and one half revolutions during the period when the pulses were generated. Alternatively, a gearing mechanism (not shown) drives drum 41 and encoder 77 can be coupled to one of the rotating gears in the gearing mechanism. Given that the gear ratios are readily known, the number of rotations of drum 41 can be calculated in a manner similar to that disclosed above.

In the illustrated embodiment, PLC 69 is also connected to a 60 ppr encoder 85 via lines 87 and 89. Encoder 85 is coupled to the shaft 59 of motor 53 and produces pulses on lines 87 and 89 as a function of the rotational movement of the shaft. The PLC 69 thus counts the pulses on lines 87 and 89 to determine exactly how much shaft 59 has rotated during any given period of interest. Encoder 85 is preferably operated in a 4X mode wherein the encoder emits 240 pulses for each 360 rotation of the shaft. Accordingly, if PLC 69 counts 480 pulses on lines 87 and 89, then it is known that the shaft 59 of motor 53 rotated exactly two complete revolutions during the period When the pulses were generated.

The PLC 69 is also programmed via conventional means with the size of drum 41 and with the gear ratios which connect shaft 59 of motor 53 to shaft 63 which turns drum 41. Given that the number of rotations of shaft 59 is known from the number of pulses on lines 87 and 89, given that the gear ratio coupling shaft 59 to drum 41 is known, and given that the diameter of drum 41 is known, PLC 69 is readily programmed via conventional means to convert the number of pulses received from encoder 85 into a numeric figure representing the linear movement of cable 37 in real time. In other words, by counting the pulses on lines 87 and 89, PLC 69 readily calculates the pull velocity of cable 37. Preferably, a display monitor 91 displays this cable velocity in real time.

A servo amplifier 93 is connected to the motor 53 via lines 95 and 97 and to a tachometer 101 via lines 103 and 105 in a conventional closed loop feedback arrangement. The tachometer 101 produces an analog signal on lines 103 and 105 which varies in voltage as a function of the rotational speed of the shaft 59 of motor 53. The servo amplifier 93 receives the analog voltage signal on lines 103 and 105. Servo amplifier 93 also receives a set point signal from a set point adjusting circuit 109 via lines 111 and 113. For example, the set point adjusting circuit 109 comprises a DC to DC convertor. PLC 69 controls set point adjusting circuit 109 and, hence, the set point signal via lines 117 and 119, as explained more fully below. In this mariner, PLC 69 controls the speed of motor 53.

More particularly, servo amplifier 93 responds to the set point signal on lines 111 and 113 by producing a current signal which is supplied to motor 53 via lines 95 and 97. The current signal energizes the motor and determines its speed. Servo amplifier 93 then uses the analog voltage signal received from tachometer 101 to determine whether motor 53 is operating at the speed which corresponds to the set point signal. If not, servo amplifier 93 adjusts the current signal up or down, as the case may be, until the analog voltage signal from tachometer 101 indicates that motor 53 is operating at the speed set by the set point signal. Again, since PLC 69 controls the set point signal via lines 117 and 119, PLC 69 controls the speed of motor 53.

The PLC 69 is also connected to a signal conditioning circuit 123. Signal conditioning circuit 123 is connected to servo amplifier 93 for receiving and conditioning the analog voltage signal produced by tachometer 101. PLC 69 receives the conditioned analog voltage signal from circuit 123 and converts it to a numeric value corresponding to the pull velocity of cable 37. PLC 69 displays this numeric value via a display 125.

Although it is seen that the actual pull velocity of cable 37 is redundantly displayed on displays 91 and 125, those skilled in the art will recognize that display 91 can display the reported velocity with far greater accuracy than display 125. This is because the source of the data underlying the velocity reported on display 91 is the highly precise and accurate encoder 85 operating in the 4X mode. By contrast, the underlying data for the velocity reported on display 125 is the analog signal produced by tachometer 101. Such a signal is inherently less accurate and is subject to substantial temperature variations, among others. In short, the present invention could readily be practiced without display 125.

Given sufficient cooling time, perfect silicon can be produced provided that the ratio of the growth rate or velocity, v, and the average axial temperature gradient, G, is within some tolerance, T, of a critical value, (v/G)cr. This tolerance may be defined by:

$$ T = \frac{1}{2} \frac{\Delta\left(v/G\right)}{\left(v/G\right)} $$

where $\Delta(v/G)$ is the range of values of v/G for which perfect silicon can be produced.

The tolerance depends strongly on the cooling conditions provided by a given hot zone. Specifically, T increases with increasing cooling time before nucleation. Data collected for a variety of hot zones suggest a value of T = 0.055 as a preferred tolerance. Reexpressing:

$$ |T| = \left|\frac{\Delta v}{v}\right| + \left|\frac{\Delta G}{G}\right| $$

However, G is generally difficult to control. If G does not vary, the maximum error in v for ensuring perfect si'licon growth could be |T|. For a robust process, a much smaller variation of v is preferred (*e.g.*, 10% of |T|).

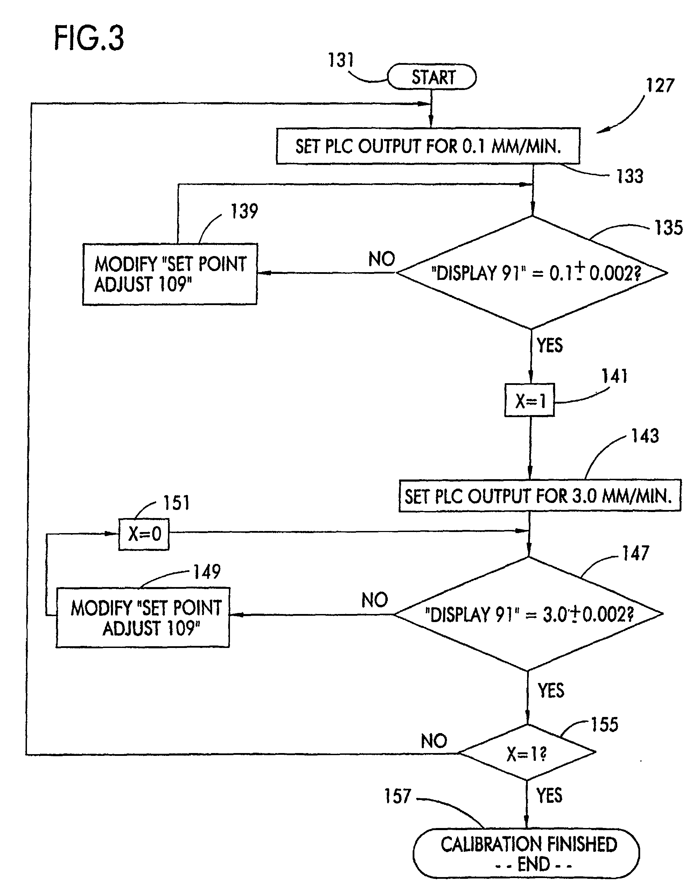

FIG. 3 shows a flow chart, generally indicated at 127, for calibrating apparatus 11 of FIG. 2. Beginning at step 131, the flow chart 127 immediately proceeds to step 133 wherein an operator adjusts external controls (not shown) on PLC 69 for a nominal cable velocity of 0.1 mm/min. At step 135, the operator observes the cable velocity reported on display 91. If the reported velocity is not within 0.002 mm/min. of 0.1 mm/min. (*i.e.*, 0.1 ± 0.002 mm/min.), then the operator proceeds to step 139. The operator "tweaks" the offset parameter for set point adjusting circuit 109 at step 139 and then returns to step 135. If the displayed cable velocity is still not $0.1 \pm 0.002$ mm/min., the operator continues tweaking the offset parameter for circuit 109 until the reported cable velocity on display 91 is equal to $0.1 \pm 0.002$ mm/min. At this point, the operator proceeds to step 141 for assigning a value of "1" to a variable, x, to indicate that step 135 was successfully accomplished.

The flow chart 127 continues with step 143 where the operator of apparatus 11 adjusts the external controls on PLC 69 for a nominal cable velocity of 3.0 mm/min. At step 147, the operator again observes the cable velocity reported on display 91. If the reported velocity is not equal to $3.0 \pm 0.002$ mm/min., then the operator proceeds to step 149 for tweaking the gain parameter of set point adjusting circuit 109. In this instance, the variable, x, is set to zero at step 151 before the operator returns to step 147. At step 147, the operator reads display 91 again to see whether it now reports a cable velocity of $3.0 \pm 0.002$ mm/min. If not, the operator continues tweaking the gain parameter for circuit 109 at step 149 until the reported cable velocity on display 91 is equal to $3.0 \pm 0.002$ mm/min. At this point, the operator proceeds to step 155. Flow diagram 127 returns to step 133 since the variable, x, is zero instead of one. In this manner, the operator continues finely calibrating the circuitry. This calibration continues until PLC 69 can be switched between nominal settings of 0.1 and 3.0 mm/min. with the result that the actual cable velocity is equal to these nominal settings $\pm 0.002$ mm/min. (and without any further tweaking of circuit 109). At this point, the variable, x, will remain at a value of one and, thus, allow the operator to proceed to step 157 where the calibration successfully concludes.

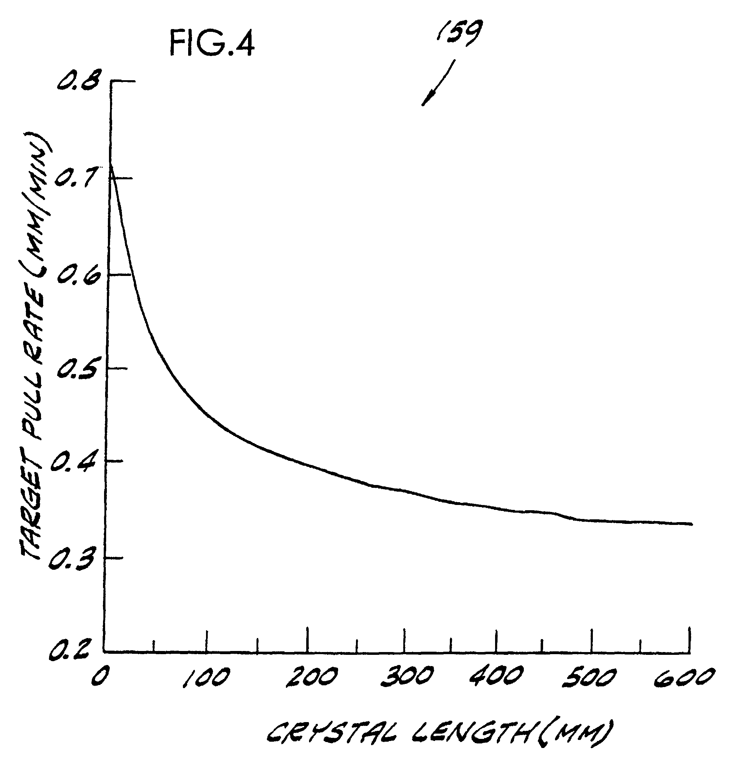

FIG. 4 shows an exemplary velocity profile, indicated generally at 159, for pulling single crystal silicon ingot 31. Accurately pulling the crystal 31 from melt 29 according to a predetermined velocity profile, or target, specified in a crystal "recipe" helps satisfy process needs for controlling the formation of defects. This type of "locked seed lift" control reduces the number and concentration of intrinsic point defects in the ingot. In addition, a locked seed lift process helps control the concentration of vacancies and self-interstitials to prevent an agglomeration of intrinsic point defects in crystal 31 as the ingot cools from the solidification temperature.

The velocity profile 159 defines a target pull rate as a function of the length of crystal 31 during the pull. According to a preferred embodiment of the invention, pulling crystal 31 according to velocity profile 159 produces silicon with a nearly perfect crystalline structure and having very few intrinsic point defects. The concentration of intrinsic point defects in such silicon at the time of solidification would certainly be well below the level of critical supersaturation making it very unlikely that an agglomeration event would occur. Such control of the concentration of vacancies and self-interstitials to prevent an agglomeration of intrinsic point defects in the ingot as the ingot cools from the solidification temperature is very desirable. U.S. Patent No. 5,919,302 provides further information concerning the velocity profile of FIG. 4 and the production of silicon having a nearly perfect crystalline structure.

In use, the velocity profile 159 of FIG. 4 is stored in the memory 73 of PLC 69. Profile 159 could also be stored in the registers or related memory circuits of CPU 71 within the scope of the invention. Those skilled in the art will recognize that the velocity profile 159 of FIG. 4 is shown here for exemplary purposes and that the present invention can be practiced with any suitable velocity profile.

In the course of working with velocity profiles such as profile 159 of FIG. 4, it has been found important that the pull rate of crystal 31 follow the velocity profile very accurately at all crystal lengths during the pull. Preferably, apparatus 11 controls the pull rate of crystal 31 so that it follows velocity profile 159 within about 0.008 mm/min or less for the majority of the crystal length. In other words, the pull rate is approximately equal to the target rate. Although the present may be practiced where the pull rate of crystal 31 follows the velocity profile accurate to within $\pm 0.008$ mm/min., $\pm 0.006$ mm/min. or $\pm 0.004$ mm/min., or even to within $\pm 0.002$ mm/min, it is to be understood that the best results are attained with an accuracy of $\pm 0.002$ mm/min. or better and that accuracy even better than $\pm 0.002$ mm/min falls within the scope of the invention.

In a preferred embodiment of the invention, PLC 69 uses a 12 bit digital to analog card for producing the control signal for the set point adjusting circuit (*i.e.,* circuit 109 in FIG. 2). Those skilled in the art will recognize that changes can be made within the scope of the invention to improve the accuracy of the present embodiment. For example, the use of a 14 bit card, instead of a 12 bit, should result in improved accuracy.

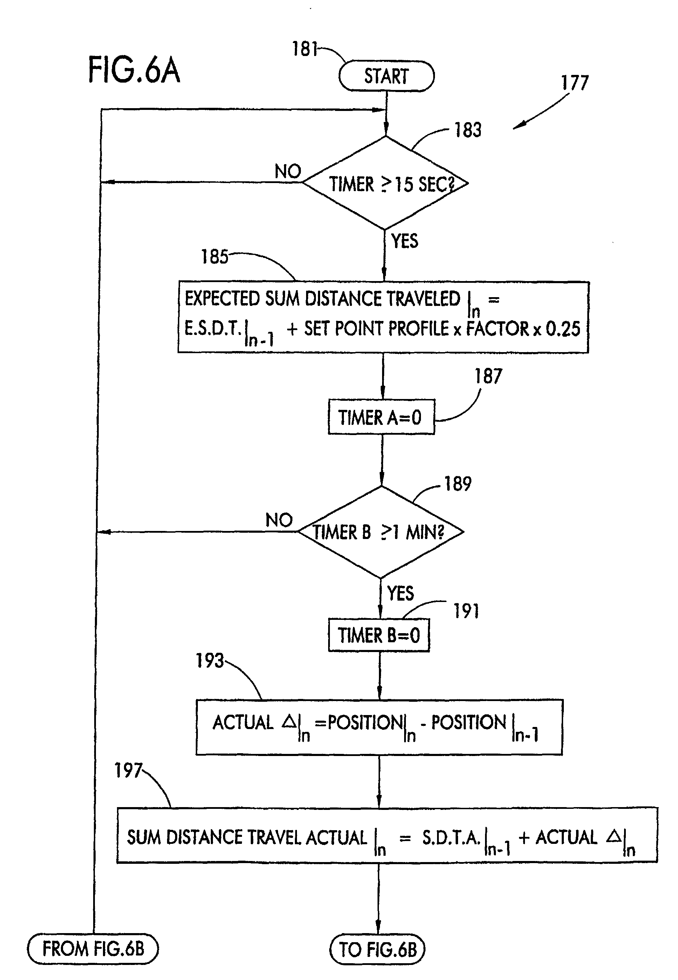

FIG. 5 is a block diagram showing how PLC 69, once loaded with profile 159, controls the rate of a crystal pull accurate to within $\pm 0.002$ mm/min. of profile 159 throughout the pull. Preferably, PLC 69 performs the functions within a dashed line 165. More particularly, PLC 69 calculates the actual pull rate from the output of encoder 77 and compares it to what is expected to occur, that is, the target rate defined by the velocity profile 159 stored in memory 73. PLC 69 then uses the difference between the expected results and the actual results to calculate a correction factor 169. PLC 69 calculates a set point 173 by determining the point along the velocity profile 159 at which the pull is then occurring. By multiplying the correction factor 169 times the set point 173, PLC 69 thus calculates a modified set point 175. PLC 69 outputs the modified set point 175 to the set point adjusting circuitry 109 to control the rate of the crystal pull. As explained above, adjusting the set point in this manner keeps the crystal pull rate within $\pm 0.002$ mm/min. of profile 159 throughout the pull.

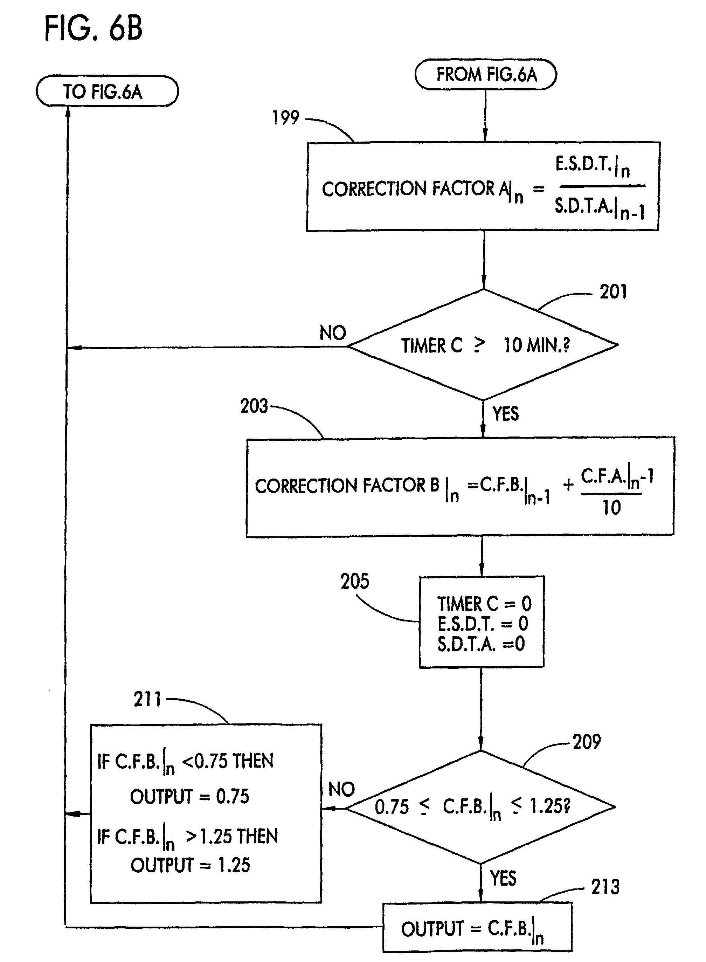

FIGS. 6A and 6B show a flow chart, indicated generally at 177, providing greater detail on the operation of PLC 69. In particular, the flow chart 177 illustrates how PLC 69 calculates the correction factor 169 of FIG. 5. Flow chart 177 begins at step 181 and immediately proceeds to step 183. At step 183, PLC 69 tests whether a predetermined interval of time (e.g. 15 seconds) has elapsed since the last time an "expected sum distance traveled" (E.S.D.T.) variable was updated. If the 15 second interval has not expired, PLC 69 repeats step 183 until it has. After 15 seconds expire, PLC 69 proceeds to step 185.

At step 185, PLC 69 updates E.S.D.T. by adding the incremental distance that it expected crystal 31 to have been pulled since the last update to the existing E.S.D.T. value. It is noted that the "set point profile" is the instantaneous expected crystal pull rate determined from velocity profile 159 as a function of crystal length. It is also noted that the "factor" identified in step 185 is a factor which, depending on the setup, may be adjusted slightly to move melt level 45 relative to the pull or to keep the pull of crystal 31 substantially constant relative to melt level 45. International Patent Application No. PCT/US99/22715 (European Patent Application No. 99954694.8) filed 30 September 1999, now published as International Patent Publication No. WO 00/22200 (European Patent Publication No. 1133592), discloses these considerations more fully. The factor of step 185 may also be adjusted near the end of a crystal pull as melt 29 is being depleted from crucible 19. Throughout most of the crystal pull when melt level 45 is fairly constant, the factor of step 185 preferably has a numeric value of "one". Finally, the 0.25 multiplier in step 185 is used since the relevant period of time is 15 seconds or 0.25 minutes.

After updating the E.S.D.T. value, PLC 69 resets Timer A at step 187 and proceeds to step 189 for determining whether another predetermined interval of time (e.g., one minute) has passed since the last time a Correction Factor A (C.F.A.) was updated. If the one minute interval has not so passed, the process returns to the beginning and waits for the 15 second interval to again update E.S.D.T. When one minute finally passes, PLC 69 resets Timer B to zero at step 191 and then proceeds to step 193. At step 193, PLC 69 determines how many pulses encoder 77 produced since the last update. Knowing the diameter of drum 41, PLC 69 converts this incremental pulse count to the incremental distance crystal 31 was pulled as explained above. This incremental value is equal to the "actual delta(n)" value to conclude step 193.

Proceeding to step 197, PLC 69 calculates the distance crystal 31 has been pulled to present as represented by a "sum distance travel actual" variable (S.D.T.A.). PLC 69 updates the S.D.T.A. value by simply adding its old value to the "actual delta(n)" value calculated in the immediately preceding step 193.

Referring now to FIG. 6B, flow diagram 177 continues at step 199. At step 199, PLC 69 calculates a first correction factor, Correction Factor A (C.F.A.), by dividing the current E.S.D.T. by the current S.D.T.A. PLC 69 proceeds to step 201 for determining whether a third predetermined interval of time (e.g., 10 minutes) has passed since the last time a second correction factor, Correction Factor B (C.F.B.), was updated. If the 10 minute interval has not expired, the process returns to step 183 and waits for the 15 second interval to update the E.S.D.T. value again. When ten minutes has finally passed, PLC 69 updates C.F.B. at step 203 by subtracting one from the current C.F.A., then dividing the result by ten and adding that to the previous C.F.B. PLC 69 then proceeds to step 205 where it resets Timer C, E.S.D.T., and S.D.T.A. to zero.

Preferably, the C.F.B. value is relatively close to one. For this reason, PLC 69 tests at step 209 whether the current C.F.B. is greater than or equal to 0.75 or less than or equal to 1.25. If C.F.B. is within this range, PLC 69 outputs a current C.F.B at step 211 as the correction factor 169 in FIG. 5 before returning to the beginning of flow chart 177. If C.F.B. is outside this range, however, PLC 69 sets C.F.B. at step 213 depending on whether the current value is too high or too low. If the current C.F.B. is too low, PLC 69 outputs 0.75 as correction factor 169 but if it is too high, PLC 69 outputs 1.25 as correction factor 169. PLC 69 then returns to the beginning of flow chart 177.

Those skilled in the art recognize that crucible 19 should be lifted during the crystal pull. Given the relatively small distance crucible 19 travels during a typical pull, it is readily seen that the crucible lifting is far less critical than the crystal pulling for reducing defects. A suitable equation for lifting crucible 19 while pulling crystal 31 involves multiplying the crystal pull rate times the ratio of the cross-sectional area of the ingot to the cross-sectional area of the crucible (measured at the melt level) times the ratio of the density of silicon in the ingot to the density of the silicon in the melt. Other crucible lift equations can also be used with the scope of the invention.

In practice, it is important that the components used in constructing apparatus 11 (as well as crystal growing apparatus 13) be made to fairly tight tolerances. The following parts list provides a listing of exemplary components suitable for use with the present invention:

PLC 69: Siemens Model TI 575
Set Point Adjust 109: Ferrofluidics Part No. 207683
Servo Amp 93: Advanced Motion Controls--Model AMC 10A8
Tachometer and Servo Motor 53: Max--00 Motomatic II-Part No. 284-001-109
Encoder 85: Accu-Coder--Part No. 755A-01-0060-PU
Encoder 77: Ferrofluidics--Part No. 080010
Pulley 39: Ferrofluidics--Drawing No. 206886A
Drum 41: Ferrofluidics--Drawing No. 206075D

Cable 37: Tungsten cable .10 inches (2.54mm) in dia.

In view of the above, it will be seen that the several objects of the invention are achieved and other advantageous results attained.

As various changes could be made in the above constructions and methods without departing from the scope of the invention, it is intended that all matter contained in the above description or shown in the accompanying drawings shall be interpreted as illustrative and not in a limiting sense.

## Claims

1. A method for use with a crystal growing apparatus (13) for growing a monocrystalline ingot (31) according to the Czochralski process, said crystal growing apparatus (13) having a heated crucible (19) containing a semiconductor melt (29) from which the ingot (31) is grown, said ingot (31) being grown on a seed crystal (35) pulled from the melt (29), said crystal growing apparatus (13) further having a cable (37) from which the seed crystal (35) is suspended and. a drum (41) on which a portion of the cable (37) is wound, said drum (41) being rotatable in one direction for winding the cable (37) to pull the ingot (31) from the melt (29) and rotatable in an opposite direction for unwinding the cable (37) to lower the ingot (31) toward the melt (29), said method comprising the steps of:

   defining a predetermined velocity profile, said velocity profile defining a target rate for pulling the ingot (31) from the melt (29) as a function of the length of the ingot (31);
   pulling the ingot (31) from the melt (29) at a varying rate by rotating the drum (41) at a varying speed with a motor (53), said motor (53) having a shaft (55) coupled to the drum (41) for rotating the drum (41);
   detecting rotational movement of the drum (41);
   generating a position signal representative of the detected rotational movement of the drum (41);
   determining an actual pull rate of the ingot (31) based on the position signal;
   comparing the actual pull rate of the ingot (31) to the target pull rate defined by the velocity profile; and
   controlling the speed of the motor (53) to maintain the actual pull rate of the ingot (31) approximately equal to the target pull rate during the pulling of at least about 50% of the length of the ingot (31).

2. A method according to claim 1, wherein the controlling step includes maintaining the actual pull rate of the ingot (31) within approximately ±0.008 mm/minute of the target pull rate.

3. A method according to claim 1 or claim 2, wherein the controlling step includes maintaining the actual pull rate of the ingot (31) approximately equal to the target pull rate during the pulling of at least about 75% of the length of the ingot (31).

4. A method according to any one of claims 1 to 3, wherein the controlling step comprises the steps of:

   defining a set point representative of a desired motor speed; and
   energizing the motor (53) as a function of the set point; and
   further comprising the steps of:

   calculating a correction factor as a function of the difference between the actual pull rate of the ingot (31) and the target pull rate defined by the velocity profile; and
   defining a modified set point by multiplying the set point by the correction factor.

5. A method according to claim 4, further comprising the step of calibrating the apparatus, said calibrating step comprising the steps of:

   setting a first nominal pull rate;
   controlling the speed of the motor (53) to pull the ingot (31) at the first nominal pull rate;
   comparing the actual pull rate of the ingot (31) to the first nominal pull rate; and
   adjusting the set point until the difference between the actual pull rate of the ingot (31) and the first nominal pull rate is less than or equal to a threshold level.

6. A method according to claim 5, wherein the calibrating step further comprises the steps of:

   setting a second nominal pull rate greater than the first nominal pull rate;
   controlling the speed of the motor (53) to pull the ingot (31) at the second nominal pull rate;
   comparing the actual pull rate of the ingot (31) to the second nominal pull rate; and
   adjusting the set point until the difference between the actual pull rate of the ingot (31) and the second nominal pull rate is less than or equal to the threshold level.

7. A method according to claim 5 or claim 6, further comprising repeating the calibrating step until no further adjustment of the set point is needed for the differences between the actual pull rates and the respective nominal pull rates to be less than or equal to the threshold level.

8. A method according to any one of claims 1 to 7, wherein the controlling step includes controlling the speed of the motor (53) to maintain the actual pull rate of the ingot (31) within a tolerance, T, defined by:

$$T = \frac{1}{2}\frac{\Delta(v/G)}{(v/G)}$$

where v/G is a ratio of growth rate to average axial temperature gradient and Δ(v/G) defines a range of values of v/G for which silicon with reduced defects can be produced.

9. A method according to claim 8, wherein T is less than or equal to approximately 0.055.

10. A method for use with a crystal growing apparatus (13) for growing a monocrystalline ingot (31) according to the Czochralski process, said crystal growing apparatus (13) having a heated crucible (19) containing a semiconductor melt (29) from which the ingot (31) is grown, said ingot (31) being grown on a seed crystal (35) pulled from the melt (29), said crystal growing apparatus (13) further having a cable (37) from which the seed crystal (35) is suspended and a drum (41) on which a portion of the cable (37) is wound, said drum (41) being rotatable in one direction for winding the cable (37) to pull the ingot (31) from the melt (29) and rotatable in an opposite direction for unwinding the cable (37) to lower the ingot (31) toward the melt (29), said method comprising the steps of:

pulling the ingot (31) from the melt (29) by rotating the drum (41) with a motor (53), said motor (53) having a shaft (55) coupled to the motor (53).
setting a first nominal pull rate;
defining a set point corresponding to the first nominal pull rate;
energizing the motor (53) as a function of the set point to pull the ingot (31) from the melt (29) at the first nominal rate;
detecting the rotational movement of the drum (41);
generating a position signal representative of the detected rotational movement of the drum (41);
determining an actual pull rate of the ingot (31) based on the position signal;
comparing the actual pull rate of the ingot (31) to the first nominal pull rate; and
adjusting the set point until the difference between the actual pull rate of the ingot (31) and the first nominal pull rate is less than or equal to a threshold level.

**Patentansprüche**

1. Ein Verfahren zur Verwendung mit einem Kristallzieh- bzw. -züchtungs-Apparat (13) zum Ziehen eines monokristallinen Rohlings bzw. Kristallstabs (31) gemäß dem Tiegelziehverfahren bzw. Czochralski-Verfahren, wobei der Kristallzieh-Apparat (13) einen beheizten-Schmelztiegel (19), aufweist, welcher eine Halbleiterschmelze (29) enthält, aus welcher der Rohling bzw. Krislallstab (31) gezogen wird, wobei der Rohling bzw. Kristallstab (31) auf einem Keimkristall (35) gezogen wird, der aus der Schmelze (29) gezogen wird, wobei der Kristallzieh- bzw Züchtungs-Apparat (13) weiter ein Seil (37) aufweist, an welchem der Keimkristall (35) aufgehängt ist, und eine Trommel (41), auf welcher ein Teil des Seils (37) aufgewickelt ist, wobei die besagte Trommel (41) in einer Richtung zum Aufwik-keln des Seils (37) zum Ziehen des Rohlings bzw. Kristallstabs (31) aus der Schmelze (29) gedreht werden kann und in einer entgegengesetzten Richtung gedreht werden kann, um das Seil (37) zum Absenken des Rohlings bzw. Kristallstabs (31) zur Schmelze (29) hin abzusenken, wobei das besagte Verfahren die folgenden Schritte aufweist:

Definieren eines vorbestimmten Geschwindig-keitsprofils. wobei das besagte Geschwindig-keitsprofil eine Sollrate für das Ziehen des Rohlings bzw. Kristallstabs (31) aus der Schmelze (29) als eine Funktion der Länge des Rohlings bzw. Kristallstabs (31) definiert;
Ziehen des Rohlings bzw. Kristallstabs (31) aus der Schmelze (29) mit einer variierenden Rate bzw. Geschwindigkeit durch Drehen der Trommel (41) mit einer variierenden Geschwindigkeit mittels eines Motors (53), wobei der besagte Motor (53) eine mit der Trommel (41) gekoppelte Welle (55) zum Drehen der Trommel (41) aufweist;
Feststellen der Drehbewegung der Trommel (41);
Erzeugen eines Positionssignals, welches die festgestellte Drehbewegung der Trommel (41) wiedergibt;
Bestimmen einer Ist-Ziehrate des Rohlings bzw. Kristallstabs (31) auf der Grundlage des Positionssignals;
Vergleichen der Ist-Ziehrate des Rohlings bzw. Kristallstabs (31) mit der Soll-Ziehrate, welche durch das Geschwindigkeitsprofil definiert ist; und
Steuern der Geschwindigkeit des Motors (53), um die Ist-Ziehrate des Rohlings bzw. Kristallstabs (31) ungefähr gleich der Soll-Ziehrate während des Ziehens von wenigstens etwa 50% der Länge des Rohlings bzw. Kristallstabs (31) aufrecht zu erhalten.

2. Ein Verfahren gemäß Anspruch 1, wobei der Steuerschritt das Aufrechterhalten der Ist-Ziehrate des Rohlings bzw. Kristallstabs (31) innerhalb von ungefähr + 0,008 mm/min. der Soll-Ziehrate aufrecht erhält.

3. Ein Verfahren gemäß Anspruch 1 oder Anspruch 2, bei dem der Steuerschritt das Aufrechterhalten der Ist-Ziehrate des Rohlings bzw. Kristallstabs (31) von ungefähr gleich der Soll-Ziehrate während des Ziehens von wenigstens etwa 75% der Länge des Rohlings bzw. Kristallstabs (31) aufrecht erhält.

4. Ein Verfahren gemäß einem der Ansprüche 1 bis 3, wobei der Steuerschritt folgende Schritte aufweist:

   Definieren eines Sollwerts, welcher eine gewünschte Motordrehzahl repräsentiert; und Speisen des Motors (53) mit Energie als eine Funktion des Sollwerts; und weiterhin die folgenden Schritte aufweist:

   Berechnen eines Korrektionsfaktors als eine Funktion der Differenz zwischen der Ist-Ziehrate des Rohlings bzw. Kristallstabs (31) und der Soll-Ziehrate, welche durch das Geschwindigkeitsprofil definiert ist; und Definieren eines modifizierten Sollwertes durch Multiplizieren des Sollwertes mit dem Korrektionsfaktor.

5. Ein Verfahren gemäß Anspruch 4, welches weiter den Schritt der Kalibrierung des Apparats aufweist, wobei der besagte Kalibrierungsschritt die folgenden Schritte aufweist:

   Einstellen einer ersten nominalen Ziehrate; Steuern der Drehzahl bzw. Geschwindigkeit des Motors (53) zum Ziehen des Rohlings bzw. Kristallstabs (31) mit der ersten nominalen Ziehrate; Vergleichen der Ist-Ziehrate des Rohlings bzw. Kristallstabs (31) mit der ersten nominalen Ziehrate; und Einstellen bzw. Abgleichen des Sollwerts bis die Differenz zwischen der Ist-Ziehrate des Rohlings bzw. Kristallstabs (31) und der ersten nominalen Ziehrate weniger als ein oder gleich einem Schwellenwertpegel ist.

6. Ein Verfahren gemäß Anspruch 5, wobei der Kalibrierungsschritt ferner die folgenden Schritte aufweist:

   Einstellen einer zweiten nominalen Ziehrate größer als die erste nominale Ziehrate; Steuern der Drehzahl bzw. der Geschwindigkeit des Motors (53), um den Rohling bzw. Kristallstab (31) mit der zweiten nominalen Ziehrate zu ziehen; Vergleichen der Ist-Ziehrate des Rohlings bzw. Kristallstabs (31) mit der zweiten nominalen Ziehrate; und Einstellen bzw. Abgleichen des Sollwertes bis die Differenz zwischen der Ist-Ziehrate des Rohlings bzw. Kristallstabs (31) und der zweiten nominalen Ziehrate geringer als der oder gleich dem Schwellenwertpegel ist.

7. Ein Verfahren gemäß Anspruch 5 oder Anspruch 6, welches weiter die Wiederholung des Kalibrierungsschritts aufweist, bis keine weitere Einstellung bzw. Abgleichung des Sollwertes notwendig ist, damit die Differenzen zwischen den Ist-Ziehraten und den jeweiligen nominalen Ziehraten kleiner als der oder gleich dem Schwellenwertpegel sind.

8. Ein Verfahren gemäß irgend einem der Ansprüche 1 bis 7, wobei der Steuerschritt das Steuern der Drehzahl bzw. Geschwindigkeit des Motors (53) zur Aufrechterhaltung der Ist-Ziehrate des Rohlings bzw. Kristallstabs (31) innerhalb einer Toleranz T einschließt, welche definiert wird durch

$$T=\frac{1}{2}\frac{\Delta(v/G)}{(v/G)}$$

wobei v/G ein Verhältnis der Ziehrate zu dem durchschnittlichen axialen Temperaturgradienten ist und $\Delta$ (v/G) einen Bereich von Werten von v/G definiert, für welchen Silizium mit verringerten Defekten erzeugt werden kann.

9. Verfahren gemäß Anspruch 8, wobei T weniger als oder gleich ungefähr 0,055 ist.

10. Ein Verfahren zur Verwendung mit einem Kristallzieh- bzw. -züchtungs-Apparat (13) zum Ziehen bzw. Wachsen eines monokristallinen Rohlings bzw. Kristallstabs (31) gemäß dem Tiegelziehverfahren bzw. Czochralski-Verfahren, wobei der Kristallzieh- bzw. Züchtungs-Apparat (13) einen beheizten Schmelztiegel (19) aufweist, welcher eine Halbleiterschmelze (29) enthält, aus welcher der Rohling bzw. Kristallstab (31) gezogen wird, wobei der Rohling bzw. Kristallstab (31) auf einem Keimkristall (35) gezogen wird, der aus der Schmelze (29) gezogen wird, wobei der Kristallzieh-Apparat (13) weiter ein Seil (37) aufweist, an welchem der Kristallkeil (35) aufgehängt ist und eine Trommel (41), auf welcher ein Teil des Seils (37) aufgewickelt ist, wobei die besagte Trommel (41) in einer Richtung zum Aufwickeln des Seils (37) zum Ziehen des Rohlings bzw. Kristallstabs (31) aus der Schmelze (29) gedreht werden kann und in einer entgegengesetzten Richtung gedreht werden kann, um das Seil (37) zum Absenken des Rohlings bzw. Kristallstabs (31) zur Schmelze (29) abzusenken, wobei das besagte Verfahren die folgenden Schritte aufweist:

Ziehen des Rohlings bzw. Kristallstabs (31) aus der Schmelze (29) durch Drehen der Trommel (41) mittels eines Motors (53), wobei der besagte Motor (53) eine mit dem Motor (53) gekoppelte Welle (55) aufweist;

Einstellen einer ersten nominalen Ziehrate;

Definieren eines Sollwertes entsprechend der ersten nominalen Ziehrate;

Speisen des Motors (53) mit Energie als eine Funktion des Sollwertes, um den Rohling bzw. Kristallstab (31) aus der Schmelze (29) mit der ersten nominalen Rate zu ziehen;

Feststellen der Drehbewegung der Trommel (41);

Erzeugen eines Positionssignals, welches die festgestellte Drehbewegung der Trommel (41) repräsentiert;

Bestimmen einer Ist-Ziehrate des Rohlings bzw. Kristallstabs (31) auf der Grundlage des Positionssignals;

Vergleichen der Ist-Ziehrate des Rohlings bzw. Kristallstabs (31) mit der ersten nominalen Soll-Ziehrate; und

Einstellen des Sollwertes, bis die Differenz zwischen der tatsächlichen Ziehrate des Rohlings bzw. Kristallstabs (31) und der ersten nominalen Ziehrate geringer als oder gleich einem Schwellenwertpegel ist.

**Revendications**

1. Procédé destiné à être utilisé avec un dispositif de croissance de cristaux (13) pour la croissance d'un lingot monocristallin (31) selon le procédé Czochralski, ledit dispositif de croissance de cristaux (13) comportant un creuset chauffé (19) contenant un semiconducteur fondu (29) à partir duquel le lingot (31) est développé, ledit lingot (31) étant développé sur un germe cristallin (35) tiré du bain fondu (29), ledit dispositif de croissance de cristaux (13) comportant en outre un câble (37) auquel le germe cristallin (35) est suspendu et un tambour (41) sur lequel une partie du câble (37) est enroulée, ledit tambour (41) étant capable de tourner dans un sens pour enrouler le câble (37) afin de tirer le lingot (31) du bain fondu (29) et étant capable de tourner dans un sens opposé pour dérouler le câble (37) afin d'abaisser le lingot (31) vers le bain fondu (29), ledit procédé comprenant les étapes consistant à :

définir un profil de vitesse prédéterminé; ledit profil de vitesse définissant une vitesse cible pour tirer le lingot (31) du bain fondu (29) en fonction de la longueur du lingot (31) ;

tirer le lingot (31) du bain fondu (29) à une vitesse variable en faisant tourner le tambour (41) à une vitesse variable au moyen d'un moteur (53), ledit moteur (53) comportant un arbre (55) accouplé au tambour (41) pour faire tourner le tambour (41) ;

détecter le mouvement de rotation du tambour (41) ;

générer un signal de position représentatif du mouvement de rotation détecté du tambour (41) ;

déterminer une vitesse de tirage réelle du lingot (31) sur la base du signal de position ;

comparer la vitesse de tirage réelle du lingot (31) à la vitesse de tirage cible définie par le profil de vitesse ; et

commander la vitesse du moteur (53) afin de maintenir la vitesse de tirage réelle du lingot (31) à peu près égale à la vitesse de tirage cible pendant le tirage d'au moins environ 50 % de la longueur du lingot (31) .

2. Procédé selon la revendication 1, dans lequel l'étape de commande comprend le maintien de la vitesse de tirage réelle du lingot (31) égale à la vitesse de tirage cible avec une tolérance d'environ ± 0,008 mm/mn.

3. Procédé selon la revendication 1 ou la revendication 2, dans lequel l'étape de commande comprend le maintien de la vitesse de tirage réelle du lingot (31) à peu près égale à la vitesse de tirage cible pendant le tirage d'au moins environ 75 % de la longueur du lingot (31).

4. Procédé selon l'une quelconque des revendications 1 à 3, dans lequel l'étape de commande comprend les étapes consistant à :

définir un point de consigne représentatif d'une vitesse de moteur souhaitée ; et

alimenter le moteur (53) en fonction du point de consigne ; et

et comprenant en outre les étapes consistant à :

calculer un coefficient de correction en tant que fonction de la différence entre la vitesse de tirage réelle du lingot (31) et la vitesse de tirage cible définie par le profil de vitesse ; et

définir un point de consigne modifié en multipliant le point de consigne par le coefficient de correction.

5. Procédé selon la revendication 4, comprenant en outre l'étape consistant à étalonner le dispositif, ladite étape d'étalonnage comprenant les étapes consistant à :

établir une première vitesse de tirage nominale ;

commander la vitesse du moteur (53) afin de tirer le lingot (31) à la première vitesse de tirage nominale ;

comparer la vitesse de tirage réelle du lingot (31) à la première vitesse de tirage nominale ; et

ajuster le point de consigne jusqu'à ce que la différence entre la vitesse de tirage réelle du lingot (31) et la première vitesse de tirage nominale soit inférieure ou égale à un niveau de seuil.

6. Procédé selon la revendication 5, dans lequel l'étape d'étalonnage comprend, en outre, les étapes consistant à :

établir une deuxième vitesse de tirage nominale supérieure à la première vitesse de tirage nominale ;

commander la vitesse du moteur (53) afin de tirer le lingot (31) à la deuxième vitesse de tirage nominale ;

comparer la vitesse de tirage réelle du lingot (31) à la deuxième vitesse de tirage nominale ; et

ajuster le point de consigne jusqu'à ce que la différence entre la vitesse de tirage réelle du lingot (31) et la deuxième vitesse de tirage nominale soit inférieure ou égale au niveau de seuil.

7. Procédé selon la revendication 5 ou la revendication 6, comprenant en outre la répétition de l'étape d'étalonnage jusqu'à ce qu'aucun ajustement supplémentaire du point de consigne ne soit nécessaire pour que les différences entre les vitesses de tirage réelles et les vitesses de tirage nominales respectives soient inférieures ou égales au niveau de seuil.

8. Procédé selon l'une quelconque des revendications 1 à 7, dans lequel l'étape de commande comprend la commande de la vitesse du moteur (53) afin de maintenir la vitesse de tirage réelle du lingot (31) dans une tolérance, T, définie par :

$$T = \frac{1}{2} \frac{\Delta(v/G)}{(v/G)}$$

où v/G est un rapport entre une vitesse de croissance et un gradient de température axial moyen et $\Delta(v/G)$ définit un intervalle de valeurs de v/G pour lequel du silicium avec des défauts réduits peut être produit.

9. Procédé selon la revendication 8, dans lequel T est inférieure ou égale à environ 0,055.

10. Procédé destiné à être utilisé avec un dispositif de croissance de cristaux (13) pour la croissance d'un lingot monocristallin (31) selon le procédé Czochralski, ledit dispositif de croissance de cristaux (13) comportant un creuset chauffé (19) contenant un semiconducteur fondu (29) à partir duquel le lingot (31) est développé, ledit lingot (31) étant développé sur un germe cristallin (35) tiré du bain fondu (29), ledit dispositif de croissance de cristaux (13) comportant en outre un câble (37) auquel le germe cristallin (35) est suspendu et un tambour (41) sur lequel une partie du câble (37) est enroulée, ledit tambour (41) étant capable de tourner dans un sens pour enrouler le câble (37) afin de tirer le lingot (31) du bain fondu (29) et étant capable de tourner dans un sens opposé pour dérouler le câble (37) afin d'abaisser le lingot (31) vers le bain fondu (29), ledit procédé comprenant les étapes consistant à :

tirer le lingot (31) du bain fondu (29) en faisant tourner le tambour (41) au moyen d'un moteur (53), ledit moteur (53) comportant un arbre (55) accouplé au moteur (53) ;

établir une première vitesse de tirage nominale ;

définir un point de consigne correspondant à la première vitesse de tirage nominale ;

alimenter le moteur (53) en fonction du point de consigne afin de tirer le lingot (31) du bain fondu (29) à la première vitesse nominale ;

détecter le mouvement de rotation du tambour (41) ;

générer un signal de position représentatif du mouvement de rotation détecté du tambour (41) ;

déterminer une vitesse de tirage réelle du lingot (31) sur la base du signal de position ;

comparer la vitesse de tirage réelle du lingot (31) à la première vitesse de tirage nominale ; et

ajuster le point de consigne jusqu'à ce que la différence entre la vitesse de tirage réelle du lingot (31) et la première vitesse de tirage nominale soit inférieure ou égale à un niveau de seuil.

FIG.1

FIG.2

FIG.5

FIG.3

131 — START

127

SET PLC OUTPUT FOR 0.1 MM/MIN. — 133

139

MODIFY "SET POINT ADJUST 109" ← NO — "DISPLAY 91" = $0.1 \pm 0.002$? — 135

YES

X=1 — 141

143

SET PLC OUTPUT FOR 3.0 MM/MIN.

151

X=0

149

MODIFY "SET POINT ADJUST 109" ← NO — "DISPLAY 91" = $3.0 \pm 0.002$? — 147

YES

155

NO ← X=1?

157 —

YES

CALIBRATION FINISHED
- - END - -

FIG.4

**FIG.6A**

START — 181

177

183

TIMER ≥ 15 SEC?

NO ← → YES

185

EXPECTED SUM DISTANCE TRAVELED $|_n$ =
E.S.D.T. $|_{n-1}$ + SET POINT PROFILE x FACTOR x 0.25

187

TIMER A = 0

189

TIMER B > 1 MIN?

NO ← → YES

191

TIMER B = 0

193

ACTUAL $\triangle|_n$ = POSITION $|_n$ - POSITION $|_{n-1}$

197

SUM DISTANCE TRAVEL ACTUAL $|_n$ = S.D.T.A. $|_{n-1}$ + ACTUAL $\triangle|_n$

FROM FIG.6B

TO FIG.6B

## FIG. 6B

TO FIG.6A

FROM FIG.6A

199

CORRECTION FACTOR $A|_n = \dfrac{\text{E.S.D.T.}|_n}{\text{S.D.T.A.}|_{n-1}}$

201

NO ← TIMER C > 10 MIN.?

YES

203

CORRECTION FACTOR $B|_n = \text{C.F.B.}|_{n-1} + \dfrac{\text{C.F.A.}|_{n-1}}{10}$

205

TIMER C = 0
E.S.D.T. = 0
S.D.T.A. = 0

211

IF $\text{C.F.B.}|_n < 0.75$ THEN
OUTPUT = 0.75

IF $\text{C.F.B.}|_n > 1.25$ THEN
OUTPUT = 1.25

NO ← 209

$0.75 \leq \text{C.F.B.}|_n \leq 1.25?$

YES

213

OUTPUT = $\text{C.F.B.}|_n$

18